# EUROPEAN PATENT APPLICATION

(11) **EP 4 510 799 A1**
(43) Date of publication of application: **19.02.2025**
(21) Application number: 23788031.5
(22) Date of filing: 21.02.2023
(51) Int. Cl.: H05K 9/00, H01L 23/00, H01L 23/36, H01L 23/427, H05K 7/20

(54) **ELECTRONIC APPARATUS**

(30) Priority: 11.04.2022 JP 2022065379
(71) Applicant: Sony Interactive Entertainment Inc., Tokyo 108-0075 (JP)
(72) Inventor: HACHIYA, Takayuki, Tokyo 108-0075 (JP); TAMAKI, Yuta, Tokyo 108-0075 (JP); TSUCHIDA, Shinya, Tokyo 108-0075 (JP); NOZAWA, Tetsufumi, Tokyo 108-0075 (JP)
(74) Representative: D Young & Co LLP
(86) International application number: PCT/JP2023/006291
(87) International publication number: WO 2023/199608

(57) **Abstract**

Provided is an electronic device capable of preventing noise from leaking from the opening of a circuit board shield. An IC chip (24c) is disposed at an opening (41) of a circuit board shield (40), and a plurality of fixing portions (122) formed in a shield plate (120) of a heat dissipation device (100) are disposed to surround the IC chip. At least one protruding contact portion (123) is formed between two adjacent fixing portions. The heat dissipation device and the circuit board shield are in contact with each other through the fixing portions and the protruding contact portion.

## Description

### [Technical Field]

The present disclosure relates to an electronic device.

### [Background Art]

In electronic devices utilizing IC (integrated circuit) chips such as CPUs (Central Processing Units), memory, and SoCs (System on a Chip) integrating them, noise countermeasures (EMI countermeasures) for blocking noise such as electromagnetic waves emitted from IC chips (unnecessary radiation noise) are taken. In an electronic device described in PTL 1 below, the edge of a circuit board shield is in contact with a ground pattern provided on the outer peripheral portion of a circuit board, thereby preventing noise from leaking to the outside of the circuit board shield.

### [Citation List]

### [Patent Literature]

[PTL 1]
Japanese Patent Laid-Open No. 2018-148026

### [Summary]

### [Technical Problem]

To cool an IC chip, a heat dissipation device (heat pipe and heat sink) is utilized. An opening is formed in a circuit board shield, and through this opening, the heat receiving surface of the heat dissipation device is thermally connected to the integrated circuit chip. Noise countermeasures are also necessary for the opening of the circuit board shield.

It is an object of the present disclosure to provide an electronic device capable of preventing noise from leaking from the opening of a circuit board shield.

### [Solution to Problem]

An electronic device according to the present disclosure includes a circuit board having a surface facing in a first direction, an IC chip mounted on the surface of the circuit board, a circuit board shield configured to cover the surface of the circuit board and having, at a position of the IC chip, an opening for exposing the IC chip, and a heat dissipation device having a heat receiving surface and disposed in a first direction relative to the circuit board shield, the heat receiving surface being located at the opening and in contact with the IC chip. The heat dissipation device is fixed to the circuit board shield by a plurality of fixing portions disposed to surround the IC chip. At least one protruding contact portion is formed between two adjacent fixing portions of the plurality of fixing portions. The heat dissipation device and the circuit board shield are in contact with each other through the plurality of fixing portions and the at least one first protruding contact portion. With this, it is possible to prevent noise from leaking from the opening of the circuit board shield.

### [Brief Description of Drawings]

[FIG. 1A]

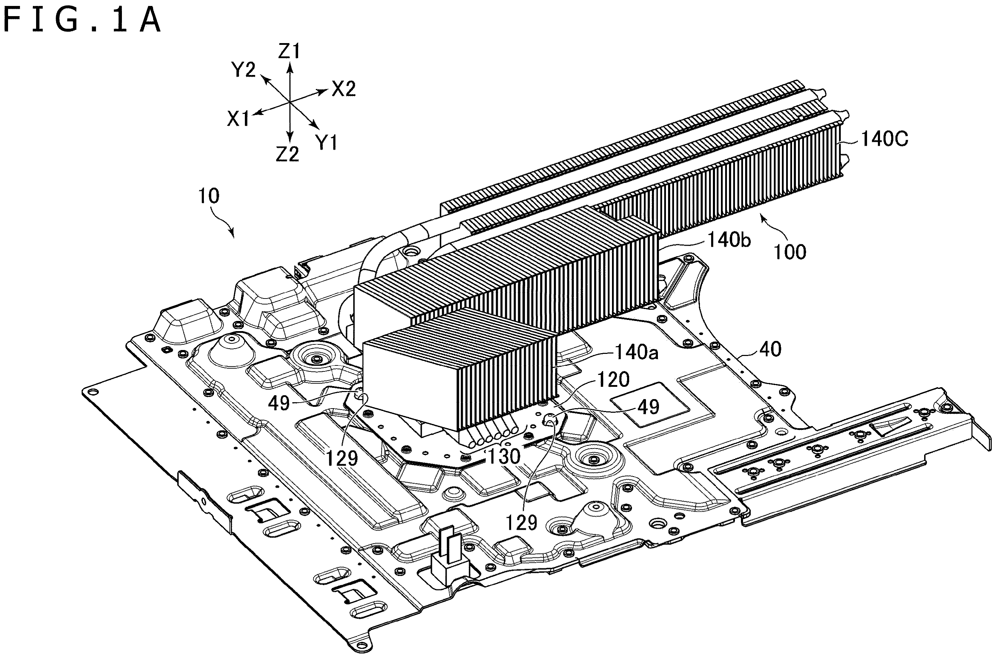

   FIG. 1A is a perspective view of a circuit board unit mounted on an electronic device serving as an exemplary embodiment of the present disclosure.
[FIG. 1B]

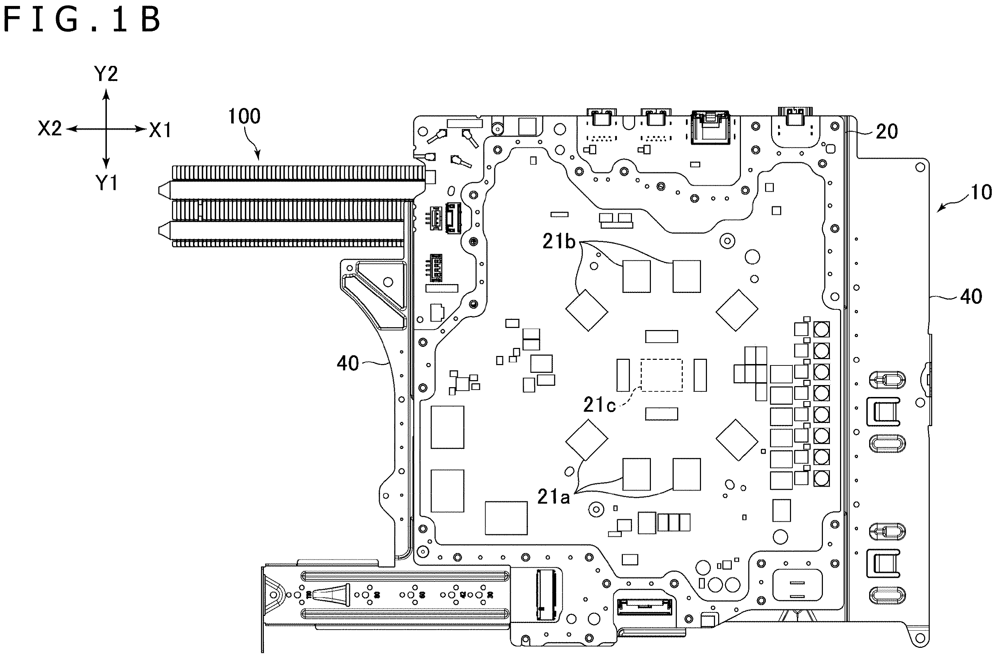

   FIG. 1B is a bottom view of the circuit board unit.
[FIG. 2]

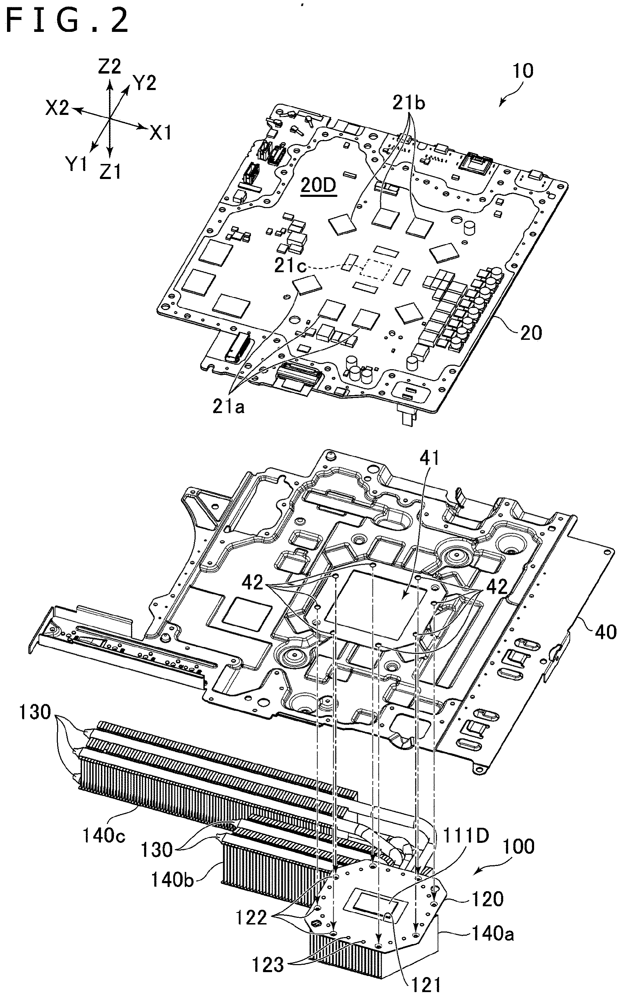

   FIG. 2 is an exploded perspective view of the circuit board unit.
[FIG. 3]

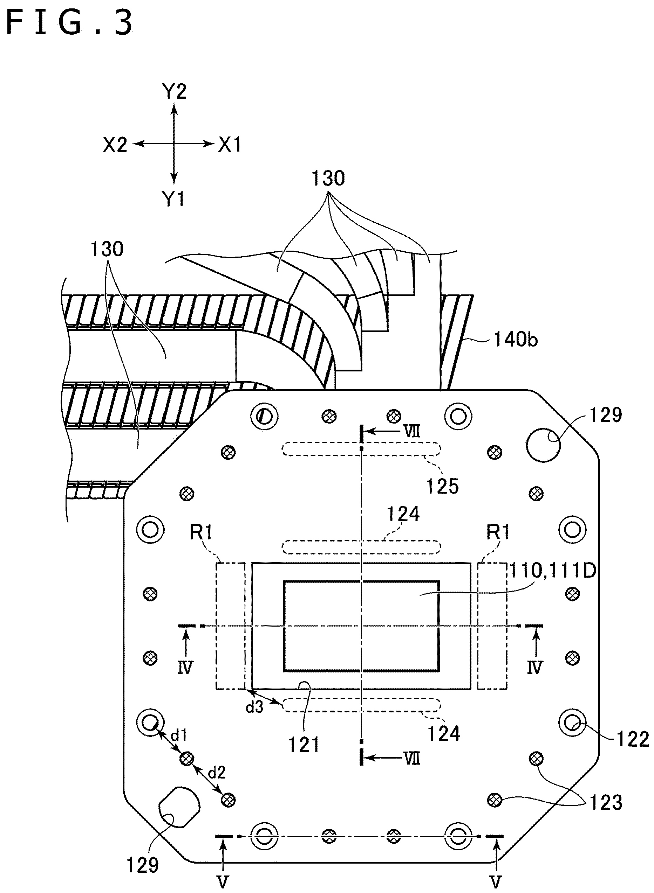

   FIG. 3 is a bottom view of a heat dissipation device.
[FIG. 4]

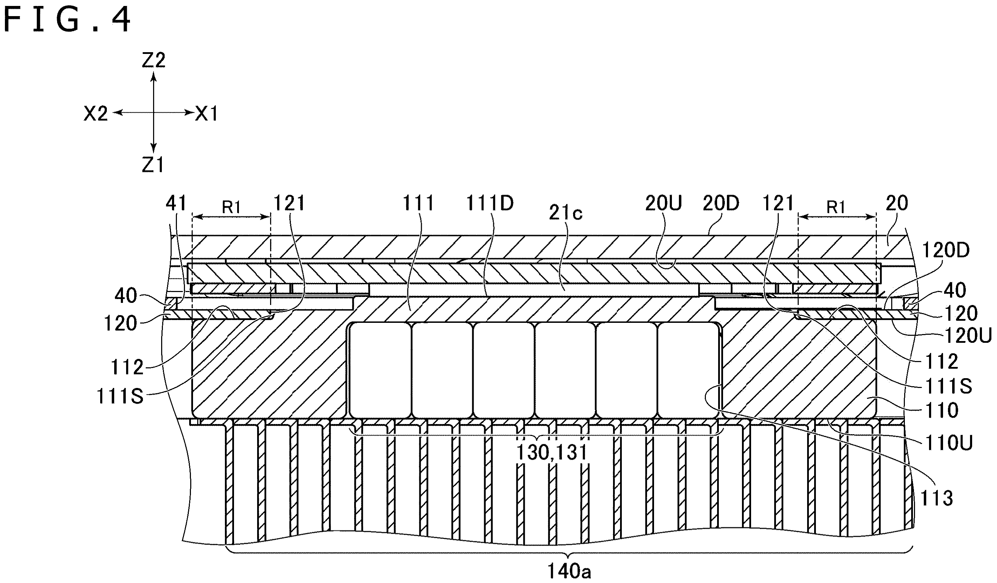

   FIG. 4 is a sectional view of the circuit board unit in a cross section including the line IV-IV of FIG. 3.
[FIG. 5]

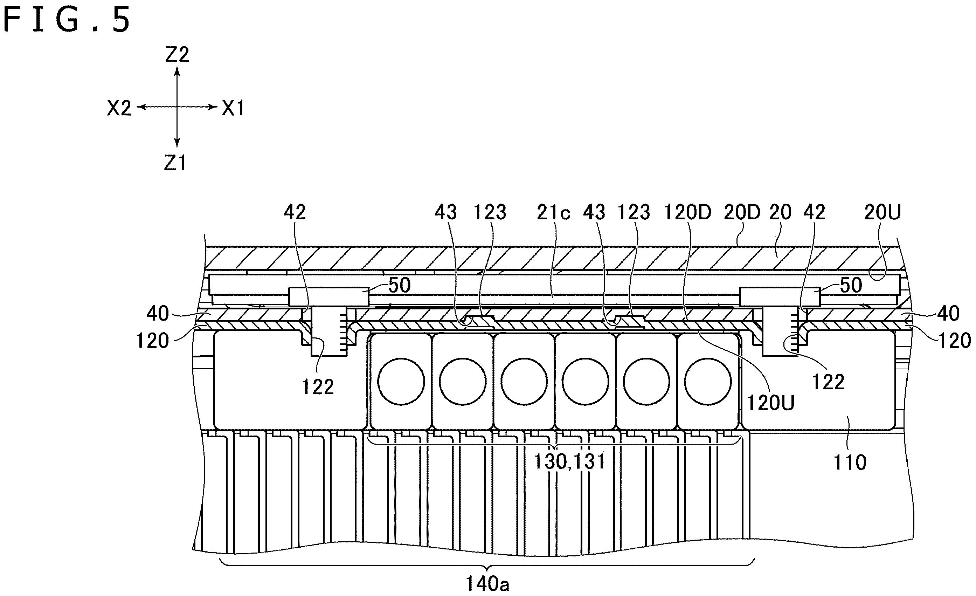

   FIG. 5 is a sectional view of the circuit board unit in a cross section including the line V-V of FIG. 3.
[FIG. 6]

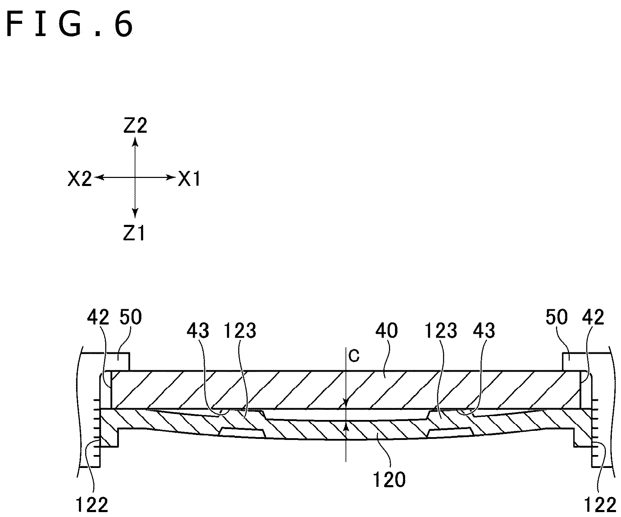

   FIG. 6 is a schematic sectional view of the circuit board unit obtained in a cross section along the mounting holes and protruding contact portions of a base plate.
[FIG. 7]

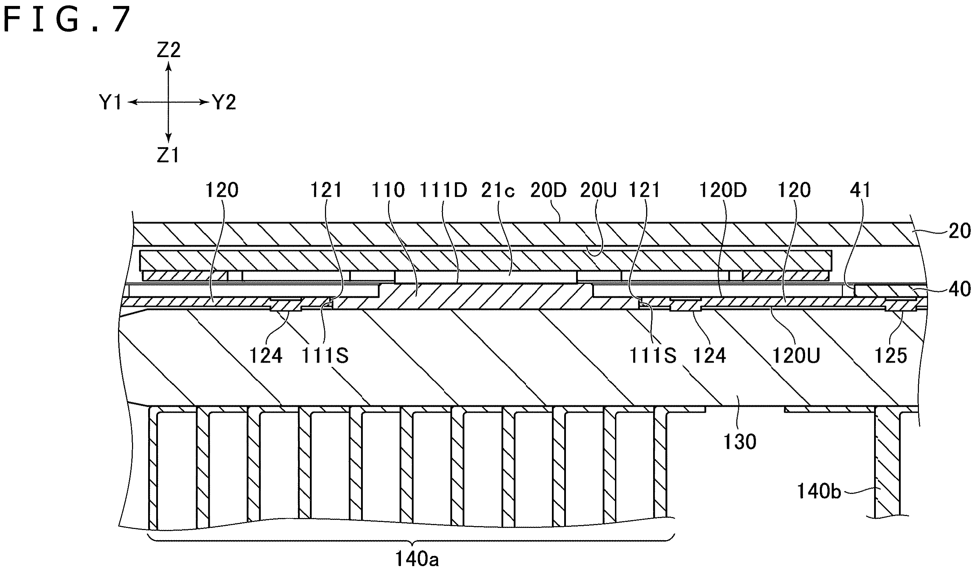

   FIG. 7 is a sectional view of the circuit board unit in a cross section including the line VII-VII of FIG. 3.
[FIG. 8]

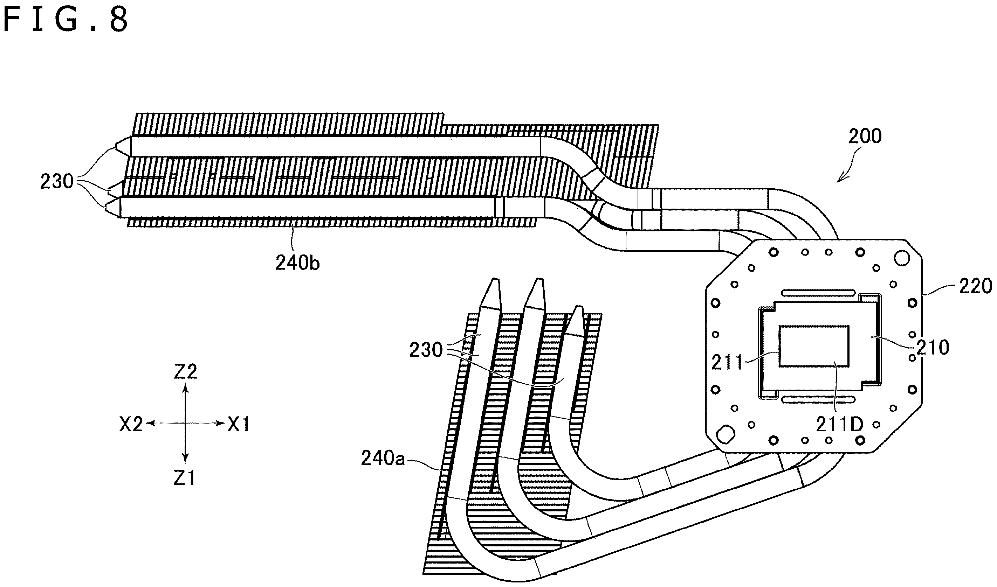

   FIG. 8 is a bottom view of a heat dissipation device mounted on an electronic device serving as another exemplary embodiment of the present disclosure.
[FIG. 9]

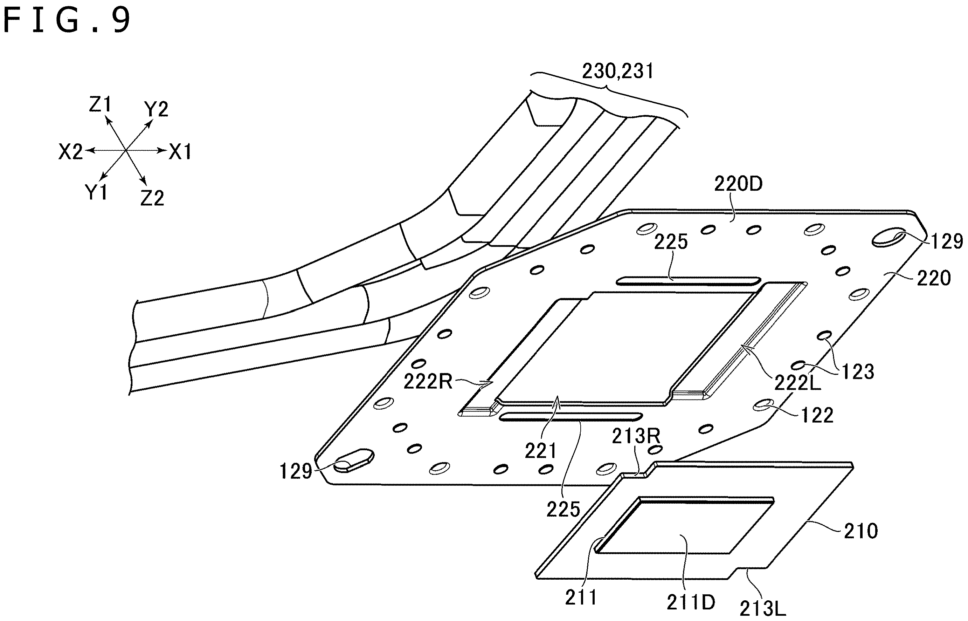

   FIG. 9 is an exploded perspective view of the heat dissipation device.
[FIG. 10]

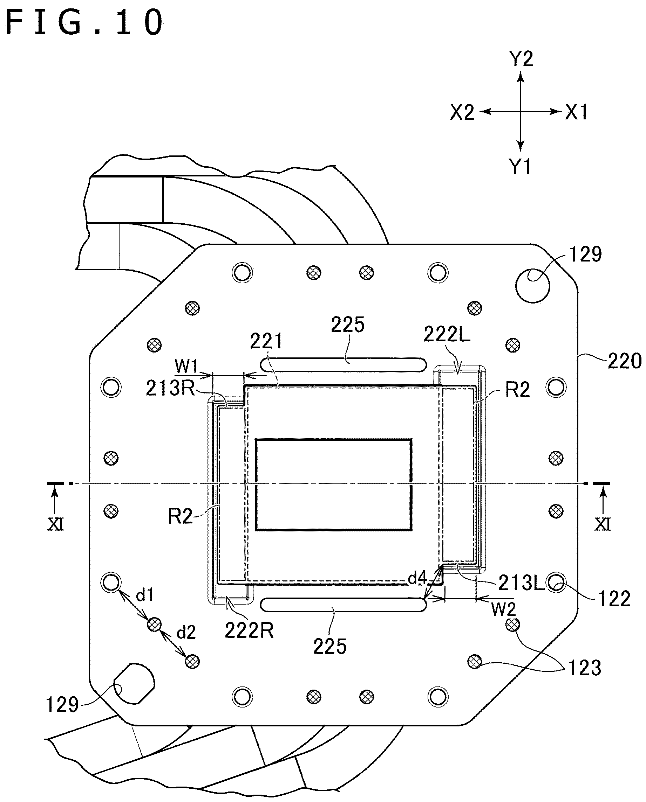

   FIG. 10 is a bottom view of the heat dissipation device and is an enlarged view of the portion of a base plate.
[FIG. 11]

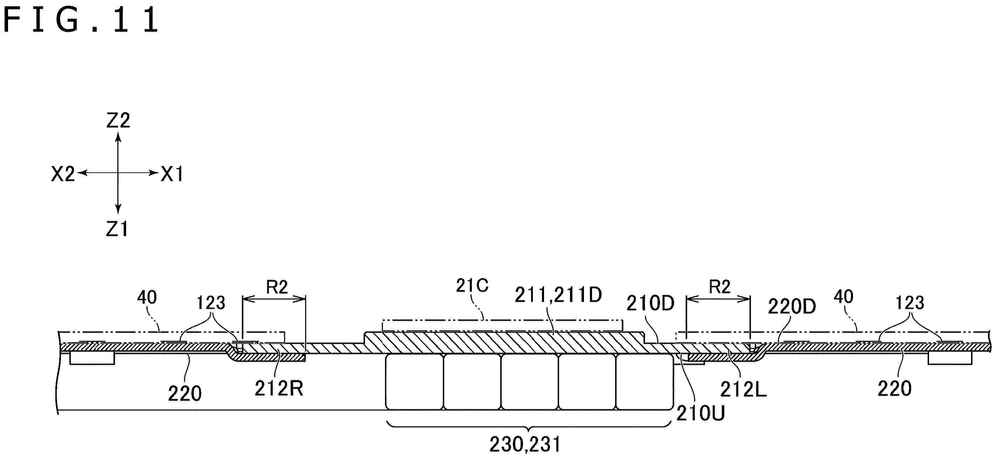

   FIG. 11 is a sectional view of the heat dissipation device in a cross section including the line XI-XI of FIG. 10.

### [Description of Embodiments]

### [1. First Embodiment]

In the following, a circuit board unit provided inside an electronic device serving as an exemplary embodiment of the present disclosure is described on the basis of FIG. 1A to FIG. 7.

### [1-1. Configuration of Circuit Board Unit]

FIG. 1A is a perspective view illustrating a front side of a circuit board unit 10. FIG. 1B is a bottom view illustrating the back side of the circuit board unit 10. FIG. 2 is an exploded perspective view illustrating the components of the circuit board unit 10.

In the following description, a Z1 direction and a Z2 direction of a Z axis illustrated in FIG. 1A and the like are referred to as "upward" and "downward," respectively. Further, a Y1 direction and a Y2 direction of a Y axis perpendicular to the Z axis are referred to as "forward" and "rearward," respectively. Further, an X1 direction and an X2 direction of an X axis perpendicular to the Z axis and the Y axis are referred to as "leftward direction" and "rightward direction," respectively. However, these directions are defined to describe the shapes and relative positional relations of the elements, such as parts, members, and portions, of the circuit board unit 10, and do not limit the posture of the circuit board unit 10 in the electronic device.

As illustrated in FIG. 2, the circuit board unit 10 includes a circuit board 20, a circuit board shield 40, and a heat dissipation device 100. The circuit board 20 has an upper surface 20U (see FIG. 4) facing upward (in a first direction, which is the direction indicated by Z1 in FIG. 2) and a lower surface 20D facing downward (in the direction indicated by Z2 in FIG. 2). As illustrated in FIG. 2, a plurality of IC chips 21a and 21b are mounted on the lower surface 20D of the circuit board 20. Further, a plurality of electronic components such as an IC chip 21c (see FIG. 4) are mounted on the upper surface 20U of the circuit board 20.

As an example, the plurality of IC chips 21a and 21b are memories such as ROM (Read Only Memory) and RAM (Random Access Memory), and the IC chip 21c is an SoC integrating a CPU, memory, and the like, but the types of the IC chips 21a, 21b, and 21c are not limited to this. At least one of the IC chips 21a, 21b, and 21c may be, for example, a GPU (Graphics Processing Unit). In the example illustrated in FIG. 1B and FIG. 2, in the planar views, the plurality of IC chips 21a and 21b surround the single IC chip 21c. The plurality of IC chips 21a surround the front side of the IC chip 21c, and the plurality of IC chips 21b surround the rear side of the IC chip 21c.

The circuit board shield 40 is formed using a conductive material and can be manufactured by, for example, applying sheet metal processing such as drawing to a metal plate such as iron or aluminum. The circuit board shield 40 is fixed to the circuit board 20 by a plurality of screws, rivets, or the like. The circuit board shield 40 covers the upper surface 20U of the circuit board 20. Further, the outer peripheral portion of the circuit board shield 40 is in contact with the ground pattern of the circuit board 20 or in contact with a shield disposed on the opposite side of the circuit board shield 40 across the circuit board 20. Then, the outer peripheral portion of the circuit board shield 40 surrounds the plurality of electronic components and wiring mounted on the upper surface 20U of the circuit board 20. With this, noise generated from the plurality of electronic components, wiring, and the like mounted on the upper surface 20U of the circuit board 20 (unnecessary radiation noise) is prevented from leaking to the outside of the circuit board unit 10.

As illustrated in FIG. 2, in the circuit board shield 40, an opening 41 for exposing the IC chip 21c is formed at the position of the IC chip 21c. The heat dissipation device 100 for cooling the IC chip 21c is installed at the position of this opening 41. The heat dissipation device 100 is installed on the circuit board shield 40 and disposed upward (in the direction indicated by Z1 in FIG. 2) relative to the circuit board shield 40.

### [1-2. Configuration of Heat Dissipation Device]

As illustrated in FIG. 1A and FIG. 2, the heat dissipation device 100 includes a heat receiving block 110 (see FIG. 3 and FIG. 4), a base plate 120, a plurality of heat pipes 130 (the six heat pipes 130 in the example illustrated in FIG. 1A), and heat sinks 140a, 140b, and 140c. The heat receiving block 110, the plurality of heat pipes 130, and the heat sinks 140a, 140b, and 140c are formed using metal and cool the IC chip 21c, which is an SoC or the like. These may be formed using metals with high thermal conductivity (for example, aluminum or copper), or may be formed using iron.

FIG. 3 is a bottom view of the heat dissipation device 100. FIG. 4 is a sectional view of the circuit board unit 10 in a cross section including the line IV-IV of FIG. 3. As illustrated in FIG. 3 and FIG. 4, the heat receiving block 110 is provided at a position corresponding to the opening 41 formed in the circuit board shield 40 and has a heat receiving surface 111D in contact with the IC chip 21c, which is an SoC or the like. Between the heat receiving surface 111D and the IC chip 21c, thermally conductive materials such as grease or liquid metals may be formed. As illustrated in FIG. 4, on the heat receiving block 110, a protruding portion 111 protruding downward (in the Z2 direction of FIG. 4) in a stepped manner is formed. The top portion of this protruding portion 111 is in contact with the heat receiving surface 111D of the IC chip 21c. Further, the heat receiving block 110 has fixing portions 112 to be fixed extending to the left side (X1 side) and the right side (X2 side) from the position of the protruding portion 111. As described later, the fixing portions 112 to be fixed are fixed to the base plate 120. The fixing portions 112 to be fixed extend in a direction intersecting with the direction in which the heat pipe 130 extends.

The base plate 120 is formed using a conductive material. For example, the base plate 120 is formed using a metal plate such as iron or aluminum. The base plate 120 is installed on the circuit board shield 40. As illustrated in FIG. 3 and FIG. 4, the base plate 120 has an opening 121 at a position corresponding to the IC chip 21c. The heat receiving block 110 is fixed to the base plate 120 by fixing means such as solder, and the heat receiving surface 111D of the heat receiving block 110 is exposed from the opening 121 of the base plate 120. The IC chip 21c is exposed at the opening 41 of the circuit board shield 40. As illustrated in FIG. 4, the opening 121 of the base plate 120 is disposed at the opening 41 of the circuit board shield 40, thereby allowing the heat receiving surface 111D of the heat receiving block 110 to be in contact with the IC chip 21c. To a lower surface 120D of the base plate 120 (see FIG. 4, in which it is the surface facing upward), for example, a sheet or sponge configured to prevent the spread of thermally conductive materials applied between the heat receiving surface 111D and the IC chip 21c may be attached to surround the heat receiving surface 111D.

As illustrated in FIG. 3, guide holes 129 are formed in the base plate 120. Further, as illustrated in FIG. 1A, protruding guide portions 49 protruding upward are formed on the circuit board shield 40. The guide protruding portions of the circuit board shield 40 pass through the guide holes 129 of the base plate 120, thereby enabling easy positioning of the base plate 120 on the circuit board shield 40.

As illustrated in FIG. 2 and FIG. 3, the plurality of heat pipes 130 and the heat sinks 140a, 140b, and 140c are located upward (in the Z1 direction, which is a downward direction in FIG. 2) of the base plate 120 to cover one of the surfaces of the base plate 120. The heat receiving block 110 provided with the heat receiving surface 111D is connected to the plurality of heat pipes 130 and transfers the heat of the IC chip 21c to the heat pipes 130. The heat pipes 130 transfer the heat of the IC chip 21c received from the heat receiving block 110 to at least one of the heat sinks 140a, 140b, and 140c. The heat sinks 140a, 140b, and 140c are connected to at least one of the plurality of heat pipes 130 and dissipate the heat of the IC chip 21c transferred through the heat pipes 130. As illustrated in FIG. 1A, in a state in which the heat dissipation device 100 is installed on the circuit board shield 40, the heat sinks 140a, 140b, and 140c have a plurality of fins located upward of the circuit board shield 40. For example, the plurality of fins are arranged in the left-right direction. The heat sink 140a is located upward of the base plate 120 and covers the opening 121 formed in the base plate 120.

As illustrated in FIG. 4, the plurality of heat pipes 130 have coupling portions 131, and the two heat pipes 130 adjacent to each other in the left-right direction are mutually coupled at the coupling portions 131. The coupling portions 131 of the heat pipes 130 are accommodated inside a recessed portion 113 provided in an upper surface 110U of the heat receiving block 110, and are disposed between the heat receiving block 110 and the heat sink 140a in the up-down direction.

### [1-3. Noise Countermeasures for Opening of Circuit Board Shield]

As illustrated in FIG. 2, the circuit board shield 40 has a plurality of mounting holes 42. The plurality of mounting holes 42 are disposed to surround the opening 41 of the circuit board shield 40. Further, as illustrated in FIG. 2 and FIG. 3, the base plate 120 of the heat dissipation device 100 also has a plurality of mounting holes 122. The plurality of mounting holes 122 are disposed to surround the opening 121 of the base plate 120. In FIG. 3, the plurality of double circles surrounding the opening 121 all indicate the mounting holes 122. In a state in which the heat dissipation device 100 is installed on the circuit board shield 40, the positions of the mounting holes 42 formed in the circuit board shield 40 match the positions of the mounting holes 122 formed in the base plate 120.

FIG. 5 is a sectional view of the circuit board unit 10 in a cross section including the line V-V of FIG. 3. The heat dissipation device 100 is fixed to the circuit board shield 40 by the plurality of mounting holes 42 and 122 (fixing portions) disposed to surround the IC chip 21c. As illustrated in FIG. 5, the mounting hole 42 formed in the circuit board shield 40 and the mounting hole 122 formed in the base plate 120 of the heat dissipation device 100 are fastened by a single fixture 50, such as a screw or a rivet, passing therethrough. With the base plate 120 of the heat dissipation device 100 fixed to the circuit board shield 40 in this manner, the stability of the contact between the circuit board shield 40 and the base plate 120 is ensured at the positions of the mounting holes 42 and 122, and it is thus possible to prevent noise generated on the circuit board 20 from passing through the opening 41 of the circuit board shield 40 and the gap formed between the circuit board shield 40 and the base plate 120, thereby leaking to the outside of the circuit board shield 40. That is, the structure on which the heat dissipation device 100 is installed itself also serves as a shield structure for noise countermeasures.

Either one of the circuit board shield 40 and the base plate 120 has protruding contact portions 123 protruding toward the other side. The protruding contact portions 123 are formed at portions of either one of the circuit board shield 40 and the base plate 120 at which they oppose each other. In the example illustrated in FIG. 3 and FIG. 5, the base plate 120 has, on the surface opposite to the circuit board shield 40, the plurality of protruding contact portions 123 (first protruding contact portions) protruding toward the circuit board shield 40 side (protruding downward (in the Z2 direction) in FIG. 5). In FIG. 3, the plurality of hatched circles surrounding the opening 121 all indicate the protruding contact portions 123. The protruding contact portions 123 are formed by applying sheet metal processing to the base plate 120. The protruding contact portions 123 are formed by sheet metal processing in this manner, thereby facilitating the formation of the protruding contact portions 123 on the base plate 120.

In a case where the protruding contact portions 123 are formed by sheet metal processing, the protruding contact portions 123 are formed on the lower surface 120D (the surface facing the Z2 side, which is the surface facing upward in FIG. 5) of the base plate 120, while an upper surface 120U (the surface facing the Z1 side, which is the surface facing downward in FIG. 5) of the base plate 120 may have recessed portions at the positions of the protruding contact portions 123. Note that the protruding contact portions 123 may not be portions formed by sheet metal processing. For example, the base plate 120 may have protruding portions formed by solder as the protruding contact portions 123.

As illustrated in FIG. 5, the circuit board shield 40 has contact portions 43 in contact with the protruding contact portions 123 of the base plate 120. The protruding contact portions 123 are formed on the base plate 120, and the circuit board shield 40 is in contact with the base plate 120 at the positions of the contact portions 43 in this manner, thereby making it possible to prevent noise generated on the circuit board 20 from passing through the opening 41 of the circuit board shield 40 and the gap formed between the circuit board shield 40 and the base plate 120 to leak to the outside of the circuit board shield 40.

As illustrated in FIG. 3, on the base plate 120 of the heat dissipation device 100, the plurality of protruding contact portions 123 are disposed to surround the opening 121 (IC chip 21c) together with the plurality of mounting holes 122. On the base plate 120, at least one protruding contact portion 123 is formed between the two adjacent mounting holes 122 of the plurality of mounting holes 122. Then, the base plate 120 and the circuit board shield 40 are in contact with each other through the plurality of mounting holes 42 and 122, and the plurality of protruding contact portions 123. Since the base plate 120 is in contact with the circuit board shield 40 at the plurality of positions surrounding the IC chip 21c in this manner, it is possible to effectively prevent noise generated on the circuit board 20 from passing through the opening 41 of the circuit board shield 40 and the gap formed between the circuit board shield 40 and the base plate 120, thereby leaking to the outside of the circuit board shield 40 (the outside of the space between the circuit board shield 40 and the circuit board 20).

FIG. 6 is a schematic sectional view of the circuit board unit 10 obtained in a cross section along the direction in which the mounting holes 122 and the protruding contact portions 123 are arranged on the base plate 120. As illustrated in FIG. 6, the base plate 120 is fixed to the circuit board shield 40 at the positions of the mounting holes 42, and with the protruding contact portions 123 in contact with the contact portions 43, the base plate 120 warps relative to the circuit board shield 40. To obtain such warping, the base plate 120 may have a lower rigidity than the circuit board shield 40. The base plate 120 may be, for example, a member with a smaller thickness in the up-down direction than the circuit board shield 40. Further, the material of the base plate 120 may be different from the material of the circuit board shield 40. The base plate 120 may be formed using a material softer than that of the circuit board shield 40. For example, the circuit board shield 40 and the base plate 120 may contain the same material, which is iron, and may be formed using sheet metals with different sheet thicknesses. In that case, the sheet thickness of the base plate 120 is preferably smaller than the sheet thickness of the circuit board shield 40. Further, the circuit board shield 40 and the base plate 120 may be formed using different materials. For example, the circuit board shield 40 may be formed using iron, and the base plate 120 may be formed using aluminum.

As illustrated in FIG. 6, with the base plate 120 warping relative to the circuit board shield 40, a gap C is formed between the two protruding contact portions 123 in some cases. Here, when the number of the protruding contact portions 123 formed between the two mounting holes 122 on the base plate 120 is three, the middle protruding contact portion 123 of these three protruding contact portions 123 may possibly be disposed near the gap C. Thus, it is desirable that the number of the protruding contact portions 123 disposed between the two mounting holes 122 on the base plate 120 be two or less. In other words, it is desirable that the number of the contact portions 43 provided between the two mounting holes 42 on the circuit board shield 40 be two or less. In such a way, the stability of the contact between the base plate 120 and the circuit board shield 40 is sufficiently ensured, and it is thus possible to enhance the performance of blocking noise generated on the circuit board 20.

The mounting holes 122 and the protruding contact portions 123 of the base plate 120 (the mounting holes 42 and the contact portions 43 of the circuit board shield 40) are contact points between the heat dissipation device 100 and the circuit board shield 40. Here, it is desirable that the distance between two adjacent contact points (a distance d1 between the mounting hole 122 and the protruding contact portion 123 (see FIG. 3) and a distance d2 between the two protruding contact portions 123 (see FIG. 3)) be determined on the basis of the wavelength of noise to be blocked by the circuit board shield 40. For example, each distance between two adjacent contact points may preferably be set to less than one-third of the wavelength of noise that the circuit board shield 40 blocks, more preferably to less than one-fourth of the wavelength. Further, each distance between two adjacent contact points is preferably 20 mm. With this, it is possible to effectively prevent the leakage of noise in frequency bands used for wireless communication or the like. Each distance between two adjacent contact points is preferably 15 mm or less. Each distance between two adjacent contact points is further preferably 10 mm or less.

### [1-4. Noise Countermeasures for Opening of Shield Plate]

The opening 121 of the base plate 120 is formed at the position of the opening 41 of the circuit board shield 40. As illustrated in FIG. 3 and FIG. 4, the opening 121 of the base plate 120 is closed by the heat receiving block 110 installed on the base plate 120. As illustrated in FIG. 4, the heat receiving block 110 has the protruding portion 111 protruding in a stepped manner. The protruding portion 111 of the heat receiving block 110 passes through the opening 121 of the base plate 120, and an outer peripheral edge 111S of the protruding portion 111 is in contact with the edges of the opening 121. In such a way, it is possible to prevent noise from leaking from the opening 121 of the base plate 120.

The base plate 120 has a shield structure surrounding the opening 121. The shield structure is formed between the heat receiving block 110 or the heat pipes 130, which transfer the heat of the IC chip 21c, and the base plate 120. With this shield structure, it is possible to effectively prevent noise generated on the circuit board 20 from passing through the opening 41 of the circuit board shield 40, the opening 121 of the base plate 120, and the gap formed between the base plate 120 and the heat receiving block 110 (or the gaps formed between the base plate 120 and the heat pipes 130), thereby leaking to the outside of the circuit board shield 40. The shield structure may have different configurations depending on the orientation of the edge of the rectangular opening 121. The shield structure may have different structures between the edges of the opening 121 along the direction in which the heat pipe 130 extends at the coupling portion 131 of the heat pipe 130 (the edges along the front-rear direction) and the edges of the opening 121 along the direction intersecting with those edges (the edges along the left-right direction).

As illustrated in FIG. 3 and FIG. 4, the heat dissipation device 100 has, as a shield structure surrounding the opening 121 of the base plate 120, for example, fixing regions R1 in which the base plate 120 and the heat receiving block 110 are mutually fixed. The fixing regions R1 are partly provided at the fixing portions 112 to be fixed of the heat receiving block 110, for example. The fixing portions 112 to be fixed extend from the position of the protruding portion 111 of the heat receiving block 110 in the direction intersecting with the extending direction of the heat pipe 130 at the coupling portion 131 of the heat pipe 130 (rightward direction and leftward direction) and in the extending direction of the heat pipe 130 (front-rear direction). The fixing regions R1 are provided along the respective two opposing sides of the opening 121 of the base plate 120. The base plate 120 and the fixing portions 112 to be fixed of the heat receiving block 110 are mutually fixed by fixing means such as solder in the fixing regions R1. As illustrated in FIG. 4, the fixing portions 112 to be fixed of the heat receiving block 110 may be fixed to the upper surface 120U (lower surface in FIG. 4) of the base plate 120. In this case, solder may be applied to the entire lower surfaces (the surfaces facing the Z2 side in FIG. 4) of the fixing portions 112 to be fixed. The base plate 120 is in contact with the heat receiving block 110 through the fixing means at the positions in the direction intersecting with the extending direction of the heat pipe 130 at the coupling portion 131 (rightward direction and leftward direction) relative to the opening 121 in this manner, thereby making it possible to effectively prevent noise generated on the circuit board 20 from passing through the gap formed between the base plate 120 and the heat receiving block 110 to leak to the outside of the circuit board shield 40.

FIG. 7 is a sectional view of the circuit board unit 10 in a cross section including the line VII-VII of FIG. 3. As illustrated in FIG. 3 and FIG. 7, the base plate 120 also has, as a shield structure surrounding the opening 121, for example, protruding contact portions 124 (second protruding contact portions) protruding toward the heat pipe 130 side (protruding upward (in the Z1 direction) in FIG. 7). The protruding contact portions 124 are formed at positions in the extending direction of the heat pipe 130 at the coupling portion 131 of the heat pipe 130 (forward direction and rearward direction) relative to the opening 121. As illustrated in FIG. 3, the protruding contact portions 124 are provided along the two opposing sides of the opening 121 and extend in the left-right direction. The base plate 120 and the heat pipes 130 configured to transfer the heat of the IC chip 21c are in contact with each other through the protruding contact portions 124. The base plate 120 is in contact with the heat pipes 130 through the protruding contact portions 124 at the positions in the extending direction of the heat pipe 130 at the coupling portion 131 (forward direction and rearward direction) relative to the opening 121 in this manner, thereby making it possible to effectively prevent noise generated on the circuit board 20 from passing through the gaps formed between the base plate 120 and the heat pipes 130 to leak to the outside of the circuit board shield 40.

The heat pipes 130 may be fixed to the protruding contact portions 124 of the base plate 120 by fixing means such as solder. With this, the stability of the contact between the base plate 120 and the heat pipes 130 is ensured at the positions of the protruding contact portions 124, and it is thus possible to effectively prevent noise generated on the circuit board 20 from leaking to the outside of the circuit board shield 40 through the gaps between the base plate 120 and the heat pipes 130. Further, as illustrated in FIG. 7, the base plate 120 may have a protruding portion 125 protruding upward on the rear side (Y2 direction side) of the rear-side protruding contact portion 124. The heat pipes 130 may be fixed to the protruding portion 125 by fixing means such as solder. In such a way, the stability of the fixation of the heat pipes 130 to the base plate 120 can be ensured.

As illustrated in FIG. 3, the fixing regions R1 provided at the positions in the direction intersecting with the extending direction of the heat pipe 130 at the coupling portion 131 of the heat pipe 130 (rightward direction and leftward direction) relative to the opening 121 of the base plate 120 extend in the extending direction of the heat pipe 130 at the coupling portion 131 (front-rear direction) on the upper surface 120U of the base plate 120 (see FIG. 4, in which it is the lower surface). Further, the protruding contact portions 124 provided at the positions in the extending direction of the heat pipe 130 at the coupling portion 131 (forward direction and rearward direction) relative to the opening 121 of the base plate 120 extend in the direction intersecting with the extending direction of the heat pipe 130 at the coupling portion 131 (rightward direction and leftward direction) on the upper surface 120U of the base plate 120 (see FIG. 7, in which it is the lower surface). With this, the shield structure including the fixing regions R1 and the protruding contact portions 124 (fixing regions R1 and protruding contact portions 124) surrounds the opening 121. With this, it is possible to prevent noise generated on the circuit board 20 from leaking to the outside of the circuit board shield 40 through the openings 41 and 121, the gap between the circuit board shield 40 and the base plate 120, the gap between the base plate 120 and the heat receiving block 110, and the gaps between the base plate 120 and the heat pipes 130). That is, the entire heat dissipation device 100 forms a shield structure as a whole, and the heat dissipation device 100 is installed on the circuit board shield 40, thereby making it possible to prevent noise from leaking to the outside of the circuit board shield 40.

The recessed portion 113 is formed in the upper surface 110U of the heat receiving block 110, and the coupling portions 131 of the heat pipes 130 located between the heat receiving block 110 and the base plate 120 extend in the front-rear direction to pass inside the recessed portion 113 of the heat receiving block 110. Thus, it is difficult to provide the fixing region R1 in which the base plate 120 is directly connected to the heat receiving block 110 at a position in the extending direction of the heat pipe 130 at the coupling portion 131. Thus, the shield structure surrounding the opening 121 of the base plate 120 is in contact with the heat pipes 130 through the protruding contact portions 124 at the positions in the extending direction of the heat pipe 130 at the coupling portion 131 of the heat pipe 130 (forward direction and rearward direction) relative to the opening 121. Meanwhile, at the positions in the direction intersecting with the extending direction of the heat pipe 130 at the coupling portion 131 (rightward direction and leftward direction) relative to the opening 121, the shield structure is in contact with the heat receiving block 110 through the fixing regions R1. The shield structure is in contact with different members (heat pipes 130 and heat receiving block 110) between the positions in the extending direction of the heat pipe 130 and the positions in the direction intersecting with the extending direction of the heat pipe 130 relative to the opening 121 in this manner, thereby being capable of surrounding the opening 121. With this, it is possible to prevent noise from leaking to the outside of the circuit board shield 40.

It is desirable that a distance d3 (see FIG. 3) between the fixing region R1 and the protruding contact portion 124 provided on the base plate 120 be determined on the basis of the wavelength of noise to be blocked by the base plate 120. For example, the distance d3 between the fixing region R1 and the protruding contact portion 124 is preferably less than one-third of the wavelength of noise that the base plate 120 blocks. The distance d3 is further preferably set to less than one-fourth of the wavelength. Further, the distance d3 between the fixing region R1 and the protruding contact portion 124 is preferably 20 mm. With this, it is possible to effectively prevent the leakage of noise in frequency bands used for wireless communication or the like. The distance d3 is preferably 15 mm or less. The distance d3 is further preferably 10 mm or less.

### [1-5. Conclusion]

As described above, in the circuit board unit 10, the heat dissipation device 100 is disposed on the circuit board shield 40 and fixed to the circuit board shield 40 by the plurality of mounting holes 122 formed in the base plate 120. The IC chip 21c is disposed at the opening 41 of the circuit board shield 40, and the plurality of mounting holes 122 are disposed to surround the IC chip 21c. At least one protruding contact portion 123 is formed between the two adjacent mounting holes 122. As a shield structure surrounding the opening 41 of the circuit board shield 40, the heat dissipation device 100 and the circuit board shield 40 are in contact with each other through the plurality of mounting holes 122 and at least one protruding contact portion 123. In such a way, the heat dissipation device 100 functions as a shield structure, and it is possible to prevent noise such as electromagnetic waves from leaking to the outside of the circuit board shield 40 from the opening 41 of the circuit board shield 40.

Further, in the heat dissipation device 100, the base plate 120 having formed therein the plurality of mounting holes 122 has the fixing regions R1 and the protruding contact portions 124 as a shield structure surrounding the opening 121 of the base plate 120. In the fixing regions R1, fixing means such as solder mutually fix the base plate 120 and the heat receiving block 110 configured to receive the heat of the IC chip 21c and transfer the heat to the heat pipes 130. Further, the base plate 120 is in contact with the heat pipes 130, which transfers the heat of the IC chip 21c, through the protruding contact portions 124. In such a way, it is possible to prevent noise generated on the circuit board 20 from leaking to the outside of the circuit board shield 40 from the opening 121 of the base plate 120.

### [2. Second Embodiment]

FIG. 8 is a bottom view of a heat dissipation device 200. The circuit board unit provided inside the electronic device may include the heat dissipation device 200 illustrated in FIG. 8 instead of the heat dissipation device 100 illustrated in FIG. 2 and the like.

FIG. 9 is an exploded perspective view of the heat dissipation device 200. As illustrated in FIG. 8 and FIG. 9, the heat dissipation device 200 includes a base plate 220, a plurality of heat pipes 230 (five heat pipes 230), and heat sinks 240a and 240b, similar to the heat dissipation device 100 illustrated in FIG. 2 and the like. Further, the heat dissipation device 200 includes a planar heat receiving plate 210 instead of the heat receiving block 110 illustrated in FIG. 3 and FIG. 4. The heat receiving plate 210, the plurality of heat pipes 230, and the heat sinks 240a and 240b are formed using metal and cool the IC chip 21c (see FIG. 2 and FIG. 11 described later), which is an SoC or the like. These may be formed using metals with high thermal conductivity (for example, aluminum or copper), or may be formed using iron. Further, the base plate 220 may be formed using a conductive material such as iron or aluminum.

As illustrated in FIG. 9, the base plate 220 has an opening 221 at its central part. In the planar view of the circuit board unit, the opening of the base plate 220 is formed at the position of the IC chip 21c. Further, as illustrated in FIG. 9, a protruding portion 211 protruding downward (in the Z2 direction of FIG. 9) is formed on the heat receiving plate 210. The top portion of this protruding portion 211 serves as a heat receiving surface 211D in contact with the IC chip 21c. As illustrated in FIG. 8 and FIG. 9, in the heat dissipation device 200, the heat receiving surface 211D of the heat receiving plate 210 is exposed downward.

FIG. 10 is a bottom view of the heat dissipation device 200 and is an enlarged view of the portion of the base plate 220. In FIG. 10, the position of the opening 221 is indicated by the dotted line. FIG. 11 is a sectional view of the heat dissipation device 200 in a cross section including the line XI-XI of FIG. 10. In FIG. 11, the positions of the IC chip 21c and the circuit board shield 40 are indicated by the long dashed double-short dashed lines.

As illustrated in FIG. 11, the heat receiving plate 210 is in contact with the plurality of heat pipes 230 at the opening 221 of the base plate 220. As illustrated in FIG. 9 and FIG. 11, the plurality of heat pipes 230 have coupling portions 231 mutually coupled in the left-right direction. As illustrated in FIG. 11, the heat receiving plate 210 is in contact with the coupling portions 231 of the heat pipes 230. The plurality of heat pipes 230 transfer the heat of the IC chip 21c received by the heat receiving surface 211D of the heat receiving plate 210 to the heat sink 240a or the heat sink 240b illustrated in FIG. 8. The heat sinks 240a and 240b dissipate the heat of the IC chip 21c transferred through the heat pipes 230. With this, the heat dissipation device 200 can cool the IC chip 21c in contact with the heat receiving surface 211D.

The heat receiving plate 210 is fixed to the base plate 220 by fixing means such as solder. As illustrated in FIG. 11, the heat receiving plate 210 has a portion 212L to be fixed located on the left side (the X1 side, which is the right side in FIG. 11) of the protruding portion 211 and a portion 212R to be fixed located on the right side (the X2 side, which is the left side in FIG. 11) of the protruding portion 211. The portions 212L and 212R to be fixed are provided on an upper surface 210U (lower surface in FIG. 11) of the heat receiving plate 210. The portions 212L and 212R to be fixed are fixed to the base plate 220 by fixing means such as solder. The portions 212L and 212R to be fixed extend in the direction intersecting with the extending direction of the heat pipe 230 (left-right direction) and extend in the extending direction of the heat pipe 230 (front-rear direction).

Further, as illustrated in FIG. 9 and FIG. 10, in the base plate 200, recessed portions 222L and 222R recessed upward are formed on the left side and right side of the opening 221. In the base plate 200, the recessed portions 222L and 222R are connected to the opening 221. Similar to the portions 212L and 212R to be fixed, the recessed portions 222L and 222R extend in the direction intersecting with the extending direction of the heat pipe 230 (left-right direction) and extend in the extending direction of the heat pipe 230 (front-rear direction).

In the heat dissipation device 100 described above, as illustrated in FIG. 4, the fixing portions 112 to be fixed of the heat receiving block 110 are fixed to the upper surface 120U (lower surface in FIG. 4) of the base plate 120. In contrast to this, in the heat dissipation device 200, as illustrated in FIG. 11, the portions 212L and 212R to be fixed of the heat receiving plate 210 are fixed to the inside of the recessed portions 222L and 222R recessed upward (downward in FIG. 11) relative to a lower surface 220D (upper surface in FIG. 11) of the base plate 220. As illustrated in FIG. 11, a lower surface 210D (upper surface in FIG. 11) of the heat receiving plate 210 and the lower surface 220D of the base plate 220 are disposed at the same position in the up-down direction.

As illustrated in FIG. 9 and FIG. 10, in the heat receiving plate 210, a notch 213L is formed at the front end portion (Y1-side end portion) of the portion 212L to be fixed on the left side (right side in FIG. 9 and FIG. 10), and a notch 213R is formed at the rear end potion (Y2-side end portion) of the portion 212R to be fixed on the right side (left side in FIG. 9 and FIG. 10). Further, the recessed portion 222L formed on the left side of the opening 221 is shifted rearward (in the Y2 direction) relative to the opening 221, and the recessed portion 222R formed on the right side of the opening 221 is shifted forward (in the Y1 direction) relative to the opening 221. Further, on the heat receiving plate 210, the width in the left-right direction of the notch 213L on the left side is different from the width in the left-right direction of the notch 213R on the right side. The width in the left-right direction of the notch 213L on left side matches the width of the recessed portion 222L on the left side, and the width in the left-right direction of the notch 213R on the right side matches the width of the recessed portion 222R on the right side.

In the example illustrated in FIG. 10, a width W1 in the left-right direction of the right notch 213R on the right side (the width of the recessed portion 222R on the right side) of the heat receiving plate 210 is narrower than a width W2 in the left-right direction of the notch 213L on the left side (the width of the recessed portion 222L on the left side). With this, in a case where an attempt is made to install the heat receiving plate 210 on the base plate 220 in a state where the left-right direction and the front-rear direction are reversed, the heat receiving plate 210 cannot be fitted into the base plate 220. Thus, it is possible to prevent the heat receiving plate 210 from being installed on the base plate 220 in a state where the left-right direction and the front-rear direction are reversed, and to prevent the position of the heat receiving surface 211D of the base plate 220 from shifting from the position designed in advance. Note that the width W2 in the left-right direction of the notch 213L on the left side (the width of the recessed portion 222L on the left side) of the heat receiving plate 210 may be narrower than the width of the notch 213R on the right side (the width of the recessed portion 222R on the right side). Also in such a way, it is possible to prevent the heat receiving plate 210 from being installed on the base plate 220 in a state where the left-right direction and the front-rear direction are reversed, and to prevent the position of the heat receiving surface 211D from shifting from the position designed in advance.

Similar to the heat dissipation device 100 described above, the base plate 220 of the heat dissipation device 200 has the plurality of mounting holes 122. In FIG. 10, the mounting holes 122 are indicated by the double circles. As illustrated in FIG. 10, the plurality of mounting holes 122 are disposed to surround the opening 221 of the base plate 220. Also in the circuit board shield 40 accommodating the circuit board, a plurality of mounting holes (for example, the mounting holes 42 illustrated in FIG. 2) may be formed at the same positions as the plurality of mounting holes 122. The base plate 220 may be fixed to the circuit board shield 40 with the plurality of mounting holes 122. The base plate 220 may be fixed to the circuit board shield 40 by fixtures such as screws or rivets fastened in the mounting holes 122. With this, the stability of the contact between the circuit board shield 40 and the base plate 220 is ensured at the positions of the mounting holes 122. Further, it is possible to prevent noise generated on the circuit board from leaking to the outside of the circuit board shield 40 and the heat dissipation device 200 (base plate 220).

Further, the base plate 220 has the protruding contact portions 123 protruding toward the circuit board shield. In FIG. 10, the plurality of hatched circles surrounding the heat receiving plate 210 indicate the protruding contact portions 123. As illustrated in FIG. 11, the plurality of protruding contact portions 123 protrude downward (in the Z2 direction). The protruding contact portions 123 may be formed by applying sheet metal processing to the base plate 220. The protruding contact portions 123 formed on the base plate 220 may be in contact with the circuit board shield 40. The circuit board shield 40 may have contact portions in contact with the protruding contact portions 123 of the base plate 220. With this, it is possible to prevent noise generated on the circuit board (for example, the circuit board 20 illustrated in FIG. 2) accommodated in the circuit board shield 40 from leaking to the outside of the circuit board shield 40 and the base plate 220.

As illustrated in FIG. 9 and FIG. 10, on the base plate 220, the plurality of protruding contact portions 123 are disposed to surround the opening 221 together with the plurality of mounting holes 122. On the base plate 220, at least one protruding contact portion 123 is formed between the two adjacent mounting holes 122 of the plurality of mounting holes 122. The base plate 220 is in contact with the circuit board shield 40 at the plurality of positions surrounding the opening 221 in this manner, thereby making it possible to effectively prevent noise generated on the circuit board from leaking to the outside of the circuit board shield 40 and the base plate 220. On the base plate 220, it is desirable that the distances d1 and d2 between two adjacent contact points (mounting hole 122 and protruding contact portion 123, or protruding contact portions 123) be determined on the basis of the wavelength of noise to be blocked. For example, each of the distances d1 and d2 may preferably be set to less than one-third of the wavelength of noise, more preferably to less than one-fourth of the wavelength. Further, each of the distances d1 and d2 is preferably 20 mm. With this, it is possible to effectively prevent the leakage of noise in frequency bands used for wireless communication or the like. Each of the distances d1 and d2 is preferably 15 mm or less. Each of the distances d1 and d2 is further preferably 10 mm or less.

Similar to the heat dissipation device 100 described above, the base plate 220 of the heat dissipation device 200 has a shield structure (for example, fixing regions R2 and protruding contact portions 225 described later) surrounding the opening 221. The shield structure is formed between the heat receiving plate 210 or the heat pipes 230 and the base plate 220. With this shield structure, it is possible to effectively prevent noise generated on the circuit board from leaking to the outside from the gaps between the heat receiving plate 210 or the heat pipes 230 and the base plate 220. The shield structure may have different structures between the edges of the opening 221 along the direction in which the heat pipe 230 extends (the edges along the front-rear direction) and the edges of the opening 221 along the direction intersecting with those edges (the edges along the left-right direction).

As illustrated in FIG. 10, the heat dissipation device 200 has, as a shield structure surrounding the opening 221 of the base plate 220, for example, the fixing regions R2 in which the base plate 220 and the heat receiving plate 210 are mutually fixed. The fixing regions R2 are provided at the portions 212L and 212R to be fixed of the heat receiving plate 210. Similar to the portions 212L and 212R to be fixed, the fixing regions R2 extend in the direction intersecting with the extending direction of the heat pipe 230 (left-right direction) and extend in the extending direction of the heat pipe 230 (front-rear direction). The fixing regions R2 are provided along the respective two opposing sides of the opening 221. In the fixing regions R2, the base plate 220 and the portions 212L and 212R to be fixed of the heat receiving plate 210 are mutually fixed by fixing means such as solder. The base plate 220 is in contact with the heat receiving plate 210 through fixing means such as solder at the positions in the rightward direction and leftward direction of the opening 221 in this manner, thereby making it possible to effectively prevent noise generated on the circuit board (for example, the circuit board 20 illustrated in FIG. 2) from passing through the gap between the base plate 220 and the heat receiving plate 210 to leak to the outside of the heat dissipation device 200.

The base plate 220 has, as a shield structure surrounding the opening 221, for example, the protruding contact portions 225 protruding toward the heat pipe 230 side (upward (in the Z1 direction) in FIG. 9). As illustrated in FIG. 10, the protruding contact portions 225 are formed at positions in the extending direction of the heat pipe 230 (forward direction and rearward direction) relative to the opening 221. The protruding contact portions 225 are provided along the two opposing sides of the opening 221.

Similar to the protruding contact portions 124 of the base plate 120 and the heat pipes 130 illustrated in FIG. 7, the protruding contact portions 225 of the base plate 220 and the heat pipes 230 are also in contact with each other. The base plate 220 is in contact with the heat pipes 230 through the protruding contact portions 225 at the positions in the extending direction of the heat pipe 230 (forward direction and rearward direction) relative to the opening 221, thereby making it possible to effectively prevent noise generated on the circuit board from passing through the gaps formed between the base plate 220 and the heat pipes 230 to leak to the outside of the heat dissipation device 200.

The heat pipes 230 may be fixed to the protruding contact portions 225 of the base plate 220 by fixing means such as solder. With this, the stability of the contact between the base plate 220 and the heat pipes 230 is ensured at the positions of the protruding contact portions 225, and it is thus possible to more effectively prevent noise from leaking to the outside of the heat dissipation device 200.

As illustrated in FIG. 10, the fixing regions R2 provided at the positions in the direction intersecting with the extending direction of the heat pipe 230 (rightward direction and leftward direction) relative to the opening 221 of the base plate 220 extend in the extending direction of the heat pipe 230 (front-rear direction). Further, the protruding contact portions 225 provided at the positions in the extending direction of the heat pipe 230 (forward direction and rearward direction) relative to the opening 221 extend in the direction perpendicularly intersecting with the extending direction of the heat pipe 230 (left-right direction). The shield structure including the fixing regions R2 and the protruding contact portions 225 surrounds the opening 221. With this, it is possible to prevent noise generated on the circuit board from leaking to the outside of the heat dissipation device 200 from the gap at the peripheral edge of the opening 221 (the gap between the base plate 220 and the heat receiving plate 210, and the gaps between the base plate 200 and the heat pipes 230).

It is desirable that a distance d4 (see FIG. 10) between the fixing region R2 and the protruding contact portion 225 provided on the base plate 220 also be determined on the basis of the wavelength of noise to be blocked by the base plate 220. For example, the distance d4 between the fixing region R2 and the protruding contact portion 225 is preferably less than one-third of the wavelength of noise that the base plate 220 blocks. The distance d4 is further preferably set to less than one-fourth of the wavelength. Further, the distance d4 between the fixing region R2 and the protruding contact portion 225 is preferably 20 mm. With this, it is possible to effectively prevent the leakage of noise in frequency bands used for wireless communication or the like. The distance d4 is further preferably 15 mm or less. The distance d4 is further preferably 10 mm or less.

As described above, in the heat dissipation device 200, the heat receiving plate 210 (more specifically, the portions 212L and 212R to be fixed) is fixed to the lower side of the base plate 220 (the upper side in FIG. 11D, more specifically, the inside of the recessed portions 222L and 222R formed in the lower surface 220D). Here, similar to the heat dissipation device 100 described above, the heat dissipation device 200 may be fixed to the circuit board shield 40 by the plurality of mounting holes 122 formed in the base plate 220. The plurality of mounting holes 122 are disposed to surround the IC chip 21c mounted on the circuit board. At least one protruding contact portion 123 is formed between the two adjacent mounting holes 122. The heat dissipation device 200 may be in contact with the circuit board shield 40 through the plurality of mounting holes 122 and at least one protruding contact portion 123. In such a way, it is possible to prevent noise such as electromagnetic waves from leaking to the outside of the heat dissipation device 200.

Further, in the heat dissipation device 200, the base plate 220 having formed therein the plurality of mounting holes 122 has the fixing regions R2 and the protruding contact portions 225 as a shield structure surrounding the opening 221 of the base plate 220. In the fixing regions R2, fixing means such as solder mutually fix the heat receiving plate 210 configured to receive the heat of the IC chip 21c and transfer the heat to the heat pipes 230, and the base plate 220. Further, the base plate 220 is in contact with the heat pipes 230 through the protruding contact portion 225. In such a way, it is possible to prevent noise from leaking to the outside of the heat dissipation device 200 at the peripheral edge of the opening 221 of the base plate 220.

Note that the present invention is not limited to the embodiments described above.
(1) For example, in the first embodiment, the example has been described in which the fixing regions R1 and the protruding contact portions 124, which serve as a shield structure surrounding the opening 121 of the base plate 120, are formed between the heat receiving block 110 configured to transfer the heat of the IC chip 21c, and the base plate 120, and between the base plate 120 and the heat pipes 130. Further, in the second embodiment, the example has been described in which the fixing regions R2 and the protruding contact portions 225 are formed between the heat receiving plate 210 configured to transfer the heat of the IC chip 21c, and the base plate 220, and between the base plate 220 and the heat pipes 230. The present invention is not limited to these. For example, in the first embodiment, the shield structure of the base plate 120 may be formed between the heat sink 140a configured to dissipate the heat of the IC chip 21c, and the base plate 120. For example, the base plate 120 may have protruding contact portions in contact with the heat sink 140a, or may have fixing regions fixed to the heat sink 140a by fixing members such as solder. Also in such a way, it is possible to prevent noise from leaking to the outside of the heat dissipation device 100 from the opening 121 of the base plate 120.
(2) Further, in the first and second embodiments, the protruding contact portions 124 and 225 are protruding portions formed on the front side and rear side of the openings 121 and 221 and extending in the left-right direction. Unlike this, for example, in the first embodiment, a plurality of protruding portions arranged in the left-right direction may be formed on the front side and rear side of the opening 121, and the plurality of protruding portions may function as protruding contact portions. In this case, the distance between two adjacent protruding contact portions is preferably less than one-third of the wavelength of noise that the base plate 120 blocks. More specifically, this distance is further preferably set to less than one-fourth of the wavelength. Further, the distance between two adjacent protruding contact portions is preferably 20 mm. Further, each distance between two adjacent protruding contact portions is further preferably 15 mm or less. Each distance between two adjacent protruding contact portions is further preferably 10 mm or less.

## Claims

1. An electronic device comprising:
a circuit board having a surface facing in a first direction;
an IC chip mounted on the surface of the circuit board;
a circuit board shield configured to cover the surface of the circuit board and having, at a position of the IC chip, an opening for exposing the IC chip; and
a heat dissipation device having a heat receiving surface and disposed in the first direction relative to the circuit board shield, the heat receiving surface being located at the opening and in contact with the IC chip, wherein
the heat dissipation device is fixed to the circuit board shield by a plurality of fixing portions disposed to surround the IC chip,
at least one protruding contact portion is formed between two adjacent fixing portions of the plurality of fixing portions, and
the heat dissipation device and the circuit board shield are in contact with each other through the plurality of fixing portions and the at least one first protruding contact portion.

2. The electronic device according to claim 1, wherein,
between the two adjacent fixing portions, two or less protruding contact portions are formed as the at least one first protruding contact portion.

3. The electronic device according to claim 1, wherein
the plurality of fixing portions and the at least one first protruding contact portion each include a contact point between the heat dissipation device and the circuit board shield, and each distance between two adjacent contact points is less than one-third of a wavelength of noise that the circuit board shield blocks.

4. The electronic device according to claim 1, wherein
the plurality of fixing portions and the at least one first protruding contact portion each include a contact point between the heat dissipation device and the circuit board shield, and each distance between two adjacent contact points is 20 mm or less.

5. The electronic device according to claim 1, wherein
the heat dissipation device includes
a base plate having an opening at the position of the IC chip, a member configured to dissipate or transfer heat of the IC chip and having a portion located in the first direction relative to the base plate, and
a shield structure surrounding the opening of the base plate and formed between the base plate and the member.

6. The electronic device according to claim 5, wherein
the shield structure has a fixing region in which the base plate and the member are mutually fixed.

7. The electronic device according to claim 6, wherein
the member includes a member configured to transfer the heat of the IC chip and has a protruding portion protruding in a direction opposite to the first direction relative to the base plate and being in contact with the IC chip.

8. The electronic device according to claim 5, wherein
the shield structure has a second protruding contact portion, and
the member and the base plate are in contact with each other through the second protruding contact portion.

9. The electronic device according to claim 5, wherein
the shield structure further includes a member configured to dissipate or transfer the heat of the IC chip and having a portion located in the first direction relative to the base plate, the shield structure having a fixing region in which the base plate and one of the members are mutually fixed and a second protruding contact portion for causing the other member to be in contact with the base plate.

10. The electronic device according to claim 9, wherein
a distance between the fixing region and the second protruding contact portion is less than one-third of a wavelength of noise that the shield structure blocks.

11. The electronic device according to claim 9, wherein
a distance between the fixing region and the second protruding contact portion is 20 mm or less.

12. The electronic device according to claim 1, wherein
the heat dissipation device includes a base plate fixed to the circuit board shield by the plurality of fixing portions, and the base plate has a lower rigidity than the circuit board shield.

13. The electronic device according to claim 12, wherein
a thickness of the base plate is smaller than a thickness of the circuit board shield.

14. The electronic device according to claim 12, wherein
the base plate is formed using a material different from a material of the circuit board shield.
